# EUROPEAN PATENT SPECIFICATION

(11) **EP 1 246 517 B1**
(45) Date of publication and mention of the grant of the patent: **22.06.2005**
(21) Application number: 02251952.4
(22) Date of filing: 19.03.2002
(51) Int. Cl.: H05K 9/00, A01K 27/00, G01P 15/135, G01P 15/08

(54) **Tuner for mounting on a circuit board**
Auf einer Schaltungsplatte zu montierender Tuner
Syntoniseur à monter sur une plaquette à circuits

(30) Priority: 22.03.2001 JP 2001082718
(43) Date of publication of application: 02.10.2002
(73) Proprietor: ALPS ELECTRIC CO., LTD., Ota-ku Tokyo (JP)
(72) Inventor: Onishi, Yukihiro, c/o Alps Electric Co., Ltd., Tokyo (JP)
(74) Representative: Kensett, John Hinton

(56) References cited:
- US-A- 4 628 412
- US-A- 5 159 537
- US-A- 5 168 428

## Description

### BACKGROUND OF THE INVENTION

### 1. Field of the Invention

The present invention relates to a tuner that is preferably applied to a digital tuner or the like.

### 2. Description of the Related Art

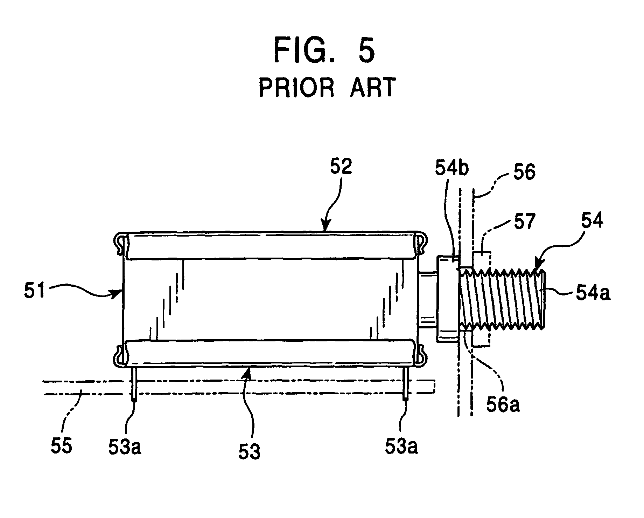

The configuration of a tuner of related art will now be described with reference to FIG. 5. The tuner shown in FIG. 5 is formed of metal plates, and includes a square frame 51 having openings in the upper and lower directions, with an upper cover 52 being attached to the upper end of the frame 51 so as to cover the upper opening and a lower cover 53 being attached to the lower end of the frame 51 so as to cover the lower opening.

The lower cover 53 is provided with a plurality of mounting lips 53a that are cut and bent so as to project downward.

While not shown herein, a circuit board on which an oscillator (OSC) circuit, RF circuit, and the like are formed is accommodated and supported in the frame 51.

A threaded coaxial connector 54 has a threaded portion 54a, a flanged portion 54b, and the like, and is attached to the frame 51 by swaging or the like and is connected to the RF circuit, so that the threaded coaxial connector 54 serves as an input portion.

The tuner configured in this manner is accommodated and installed in electronic equipment (not shown) in such a manner that the mounting lips 53a of the cover 53 are soldered to a grounding pattern (not shown) of a motherboard 55, the threaded portion 54a of the threaded coaxial connector 54 is inserted into a hole 56a of a chassis 56, and a nut 57 is fitted through the threaded portion 54a.

The tuner of the related art is mounted to the motherboard 55 by only the mounting lips 53a of the cover 53. Thus, when the nut 57 is fitted through the threaded portion 54a, there is a problem in that the frame 51 is rotated and the cover 53 is detached from the frame 51.

### SUMMARY OF THE INVENTION

Accordingly, it is an object of the present invention to provide a tuner that prevents the cover detaching from the frame and that has low noise.

To this end, according to a first aspect of the present invention, there is provided a tuner. The tuner includes a frame which is formed of a metal plate, the frame having substantially a box shape, having a plurality of sidewalls, and having an opening at the bottom; and a circuit board which is provided in the frame and which has an oscillator circuit and an RF circuit. The tuner further includes a partitioning wall which partitions the oscillator circuit and the RF circuit in the frame; a threaded coaxial connector for input, the threaded coaxial connector being attached to a first sidewall located adjacent to the RF circuit; and a cover attached to the frame so as to cover the opening. The cover has at least one mounting lip for mounting the tuner to a motherboard, the at least one mounting lip being provided adjacent to the threaded coaxial connector or the oscillator circuit and projecting downward, and at least one of the sidewalls has at least one mounting leg for mounting the tuner to the motherboard.

The cover may have a plurality of the mounting lips provided adjacent to the threaded coaxial connector and the oscillator circuit.

The at least one of the sidewalls may have a plurality of the mounting legs.

The cover may have at least one of the mounting lips at the side of the first sidewall and at the side of a second sidewall opposing the first sidewall, and the first sidewall and the second sidewall each may have at least one of the mounting legs.
An embodiment of the present invention will now be described, by way of example, with reference to the accompanying drawings, in which:
FIG. 1 is a front view of a tuner of the present invention;
FIG. 2 is a plan view of the tuner of the present invention, when an upper cover is removed;
FIG. 3 is a sectional view showing the major portion of the tuner of the present invention;
FIG. 4 is a bottom view of the tuner of the present invention; and
FIG. 5 is a front view of a tuner of related art.

### DESCRIPTION OF THE PREFERRED EMBODIMENT

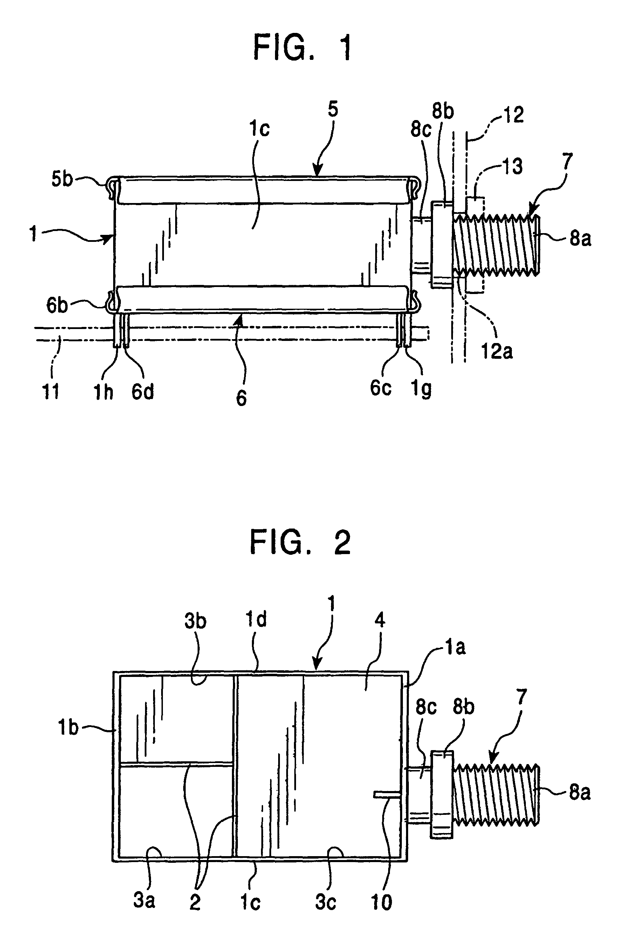

The configuration of a tuner according to the present invention will be described below with reference to FIGS. 1 to 4.

Referring now to FIGS. 1 to 4, a square frame 1, formed of metal plates, has first and second rectangular sidewalls 1a and 1b provided so as to oppose each other, third and fourth sidewalls 1c and 1d provided between edges of the first and second sidewalls 1a and 1b so as to oppose each other, opening portions 1e and 1f that are open in the upper and lower directions, respectively, and mounting legs 1g and 1h that project downward from the first and second sidewalls 1a and 1b.

Partitioning walls 2, formed of metal plates, are installed in the frame 1 such that the inside of the frame 1 is divided into a plurality of regions to provide compartments 3a, 3b, and 3c.

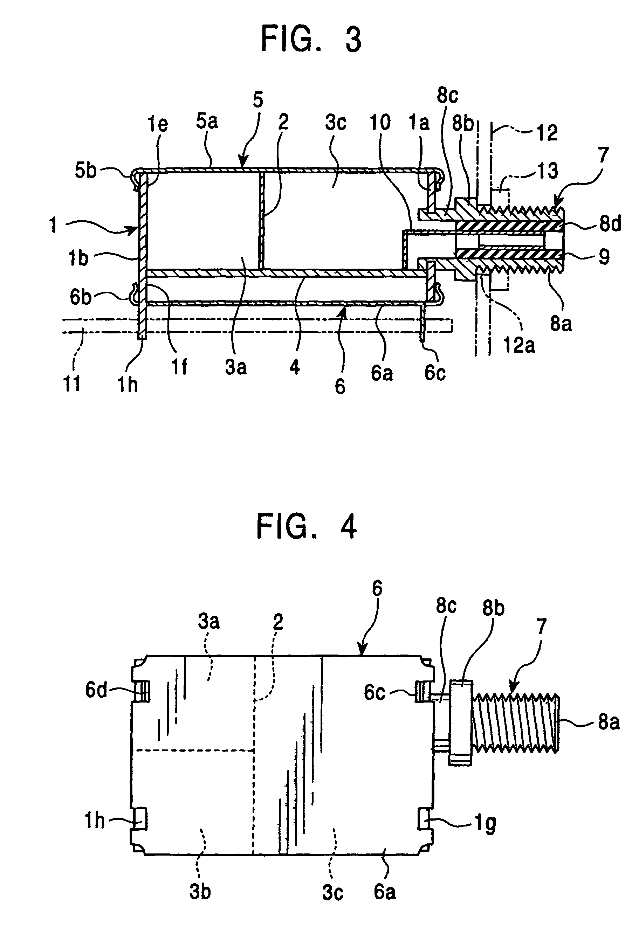

A circuit board 4 (schematically shown in FIGS. 2 and 3) has a wiring pattern, and an OSC (oscillator) circuit, IF circuit, RF circuit, and the like, all of which are not shown herein, are formed on the circuit board 4.

The circuit board 4 is arranged and supported in the frame 1 by appropriate means.

In this case, the OSC circuit is located in the compartment 3a, the IF circuit is in the compartment 3b, and the RF circuit is in the compartment 3c, which are electrically shielded from one another by the partitioning walls 2. Each of the circuits has a grounding pattern (not shown), which is part of the wiring pattern, connected to the frame 1 by soldering.

An upper cover 5, formed of a thin metal plate, has a rectangular flat-plate portion 5a and elastic lips 5b that have been bent downward from the four edges of the flat-plate portion 5a. The cover 5 is attached to the frame 1 with the elastic lips 5b holding the frame 1 such that the flat-plate portion 5a covers the upper opening 1e of the frame 1.

A lower cover 6, formed of a thin metal plate, has a rectangular flat-plate portion 6a, elastic lips 6b that have been bent upward from the four edges of the flat-plate portion 6a, and a pair of mounting lips 6c and 6d which oppose each other and which project downward.

The cover 6 is attached to the frame 1 with the elastic lips 6b holding the frame 1 such that the flat-plate portion 6a covers the lower opening 1f of the frame 1.

When the cover 6 is attached to the frame 1, as shown in FIG. 4, the mounting lip 6c is located at the side of the first sidewall 1a adjacent to the RF circuit, while the mounting lip 6d is located at the side of the second sidewall 1b adjacent to the OSC circuit. The cover 6 is attached to the frame 1 with the elastic lips 6b elastically holding the frame 1.

In addition, the mounting legs 1g and 1h, provided at the frame 1, extend beyond the plate portion 6a of the cover and project downward therefrom.

A threaded coaxial connector 7 includes a threaded portion 8a made of metal, a flanged portion 8b connected to the threaded portion 8a, a sleeve portion 8c connected to the flanged portion 8b, an insulator 9 provided in a hole 8d in the center of the threaded portion 8a, and a center conductor 10 attached to the insulator 9 of the hole 8d.

The threaded coaxial connector 7 is attached in such a manner that the sleeve portion 8c is installed in the first side wall 1a of the frame 1 by swaging and the center conductor 10, which is for input, is connected to the RF circuit.

The mounting lip 6c of the cover 6 is located adjacent to the threaded coaxial connector 7.

The tuner of the present invention configured in this manner is accommodated in electronic equipment (not shown), and the mounting lips 6c and 6d of the lower cover 6 and the mounting legs 1g and 1h are soldered to the grounding pattern (not shown) of a motherboard 11. Further, the threaded portion 8a of the threaded coaxial connector 7 is inserted into a hole 12a of a chassis 12 and a nut 13 is fitted through the threaded portion 8a, thereby allowing the tuner to be installed.

When the nut 13 is fitted through the threaded coaxial connector 7, the frame 1 is apt to rotate; however, the mounting legs 1g and 1h of the frame 1 are fixed to the motherboard 11, so that the frame 1 is not rotated. This prevents the cover 6 detaching from the frame 1.

In addition, the cover 6 is formed of a thin metal plate and the elastic lips 6b elastically hold the frame 1. Thus, in general, the flat-plate portion 6a between the first sidewall 1a, at the side of which the RF circuit is located and to which the threaded coaxial connector 7 is installed, and the second sidewall 1b, at the side of which the OSC circuit is located, tends to have resistance and to be in an unstable condition due to insufficient grounding. This may cause an oscillation signal from the OSC circuit to jump into the center conductor 10, giving rise to interference leading to noise. However, according to the tuner of the present invention, the cover 6 is directly connected to the grounding pattern of the motherboard 11 by the mounting lips 6c and 6d, adjacent to the OSC circuit and the threaded coaxial connector 7 of the RF circuit. This secures the grounding of the cover 6 and eliminates the jumping of the oscillation signal into the threaded coaxial connector 7, thereby reducing the noise.

In the above embodiment, while the description has been given for the case in which the mounting lips 6c and 6d of the cover 6 are respectively provided at the sides of first and second sidewalls 1a and 1b, at least one the mounting lips may be provided at one side of the first sidewall 1a and second sidewall 1b. Additionally, the mounting lips may be provided adjacent to the threaded coaxial connector 7 and the OSC circuit, that is, not only at the sides of the first and second sidewalls 1a and 1b but also at the sides of the third and fourth sidewalls 1c and 1d.

In addition, with reference to the mounting legs that have been provided at the frame 1, the mounting leg or legs may be provided at either one of the first to fourth sidewalls or at two or more of the first to fourth sidewalls.

In the tuner of the present invention, since the mounting legs 1g of the frame 1 is fixed to the motherboard 11, the frame 1 is not rotated when the nut 13 is fitted through the threaded coaxial connector 7. This prevents the detachment of the cover 6.

The cover 6 has mounting lips, which are provided adjacent to the threaded coaxial connector 7 or the OSC circuit and which protrude downward, for mounting the tuner on the motherboard 11. This secures the grounding of the cover 6 and eliminates the jumping of the oscillation signal into the threaded coaxial connector 7, thereby reducing the noise.

Furthermore, since the mounting lips 6c and 6d that are provided at the cover 6 are respectively arranged adjacent to the threaded coaxial connector 7 and the OSC circuit, the arrangement according to the present invention can further secure the grounding of the cover 6 and eliminate the jumping of the oscillation signal into the threaded coaxial connector 7, thereby further reducing the noise.

Additionally, since the plurality of mounting legs 1g and 1h are provided at the sidewalls, the arrangement according to the present invention can enhance the mounting strength of the frame 1 to the motherboard 11. That is, when fitting the nut 13, the frame is not rotated, which prevents detachment of the cover 6.

In addition, the mounting lips 6c and 6d are provided at the side of the first sidewall 1a and at the side of the second sidewall 1b opposing the first sidewall 1a, respectively, and the first sidewall 1a and the second sidewall 1b have mounting legs 1g and 1h, respectively, the tuner according to the present invention can enhance the mounting strength of the frame 1 and secure the grounding of the cover 6.

## Claims

1. A tuner comprising:
a frame (1) which is formed of a metal plate, said frame having substantially a box shape, having a plurality of sidewalls (1a-1d), and having an opening at the bottom;
a circuit board (4) which is provided in said frame and which has an oscillator circuit and an RF circuit;
a partitioning wall (2) which partitions the oscillator circuit and the RF circuit in said frame;
a threaded coaxial connector (7) for input, said threaded coaxial connector being attached to a first sidewall (1a) located adjacent to the RF circuit; and
a cover (5) attached to said frame so as to cover the opening,
wherein said cover has at least one mounting lip (6c) for mounting said tuner to a motherboard, said at least one mounting lip being provided adjacent to said threaded coaxial connector (7) or the oscillator circuit and projecting downward, and at least one of the sidewalls has at least one mounting leg (1g) for mounting said tuner to the motherboard.

2. A tuner according to claim 1, wherein said cover has a plurality of the mounting lips provided adjacent to said threaded coaxial connector and the oscillator circuit.

3. A tuner according to claim 1, wherein said at least one of the sidewalls has a plurality of the mounting legs.

4. A tuner according to claim 2, wherein said cover has at least one of the mounting lips at the side of the first sidewall and at the side of a second sidewall opposing the first sidewall, and the first sidewall and the second sidewall each have at least one of the mounting legs.

## Patentansprüche

1. Tuner, aufweisend:
einen Rahmen (1), der aus einer Metallplatte gebildet ist, wobei der Rahmen im Wesentlichen eine Kastenform hat, eine Mehrzahl von Seitenwänden (1a bis 1d) hat und eine Öffnung am Boden hat;
eine Platine (4), die in dem Rahmen vorgesehen ist und die eine Oszillatorschaltung und eine HF-Schaltung hat;
eine Trennwand (2), die die Oszillatorschaltung und die HF-Schaltung in dem Rahmen trennt;
einen Gewindekoaxialverbinder (7) zur Eingabe, wobei der Gewindekoaxialverbinder an einer ersten Seitenwand (1a) angebracht ist, die sich der HF-Schaltung benachbart befindet; und
eine Abdeckung (5), die an dem Rahmen derart angebracht ist, dass sie die Öffnung bedeckt,
wobei die Abdeckung mindestens eine Montagelippe (6c) zum Anbringen des Tuners an einer Hauptplatine hat, wobei die mindestens eine Montagelippe dem Gewindekoaxialverbinder (7) oder der Oszillatorschaltung benachbart vorgesehen ist und nach unten ragt, und mindestens eine der Seitenwände mindestens einen Montagefuß (1g) zum Anbringen des Tuners an der Hauptplatine hat.

2. Tuner nach Anspruch 1, wobei die Abdeckung eine Mehrzahl von Montagelippen aufweist, die dem Gewindekoaxialverbinder und der Oszillatorschaltung benachbart vorgesehen sind.

3. Tuner nach Anspruch 1, wobei die mindestens eine der Seitenwände eine Mehrzahl von Montagefüßen aufweist.

4. Tuner nach Anspruch 2, wobei die Abdeckung mindestens eine der Montagelippen an der Seite der ersten Seitenwand und an der Seite einer der ersten Seitenwand gegenüber liegenden zweiten Seitenwand aufweist und die erste Seitenwand und die zweite Seitenwand jede mindestens einen der Montagefüße aufweist.

## Revendications

1. Syntoniseur comprenant :
un cadre (1) qui est constitué d'une plaque de métal, ledit cadre ayant sensiblement la forme d'une boîte, comportant une pluralité de parois latérales (1a à 1d), et comportant une ouverture à la partie inférieure ;
une carte de circuit imprimé (4) qui est placée dans ledit cadre et qui comporte un circuit oscillateur et un circuit RF ;
une cloison de séparation (2) qui sépare le circuit d'oscillateur et le circuit RF dans ledit cadre ;
un connecteur coaxial fileté (7) d'entrée, ledit connecteur coaxial fileté étant fixé à une première paroi latérale (1a) placée de manière adjacente au circuit RF ; et
un couvercle (5) fixé audit cadre de manière à recouvrir l'ouverture,
dans lequel ledit couvercle comporte au moins une lèvre de montage (6c) destinée à monter ledit syntoniseur sur une carte mère, ladite au moins une lèvre de montage étant placée de manière adjacente audit connecteur coaxial fileté (7) ou au circuit oscillateur et faisant saillie vers le bas, et ladite au moins une des parois latérales comporte au moins une patte de montage (1g) destinée au montage dudit syntoniseur sur la carte mère.

2. Syntoniseur selon la revendication 1, dans lequel ledit couvercle comporte une pluralité de lèvres de montage placées de manière adjacente audit connecteur coaxial fileté et au circuit oscillateur

3. Syntoniseur selon la revendication 1, dans lequel ladite au moins une des parois latérales comporte une pluralité de pattes de montage.

4. Syntoniseur selon la revendication 2, dans lequel ledit couvercle comporte au moins l'une des pattes de montage sur le côté de la première paroi latérale et sur le côté d'une deuxième paroi latérale faisant face à la première paroi latérale, et la première paroi latérale et la deuxième paroi latérale comportent chacune au moins l'une des pattes de montage.
